# EUROPEAN PATENT APPLICATION

(11) **EP 3 396 018 A1**
(43) Date of publication of application: **31.10.2018**
(21) Application number: 18163577.2
(22) Date of filing: 23.03.2018
(51) Int. Cl.: C23C 16/04, C23C 16/44, F27D 7/06, F27D 19/00, H01L 21/00, H01L 21/67, F04D 13/00, F04D 15/00, F04D 27/00, F04B 41/00, C23C 16/52, F04D 17/16, F04D 19/04, F04D 27/02

(54) **COMMON VACUUM HEADER FOR CVI/CVD FURNACES**

(30) Priority: 27.03.2017 US 201715470568
(71) Applicant: Goodrich Corporation, Charlotte, NC 28217-4578 (US)
(72) Inventor: FIALA, Robert, Spokane, WA Washington 99203 (US); SCHEIBNER, Gerald H., Spokane, WA Washington 99223 (US)
(74) Representative: Dehns

(57) **Abstract**

A common vacuum header for CVI/CVD furnaces is provided. A vacuum system may comprise a furnace environment (120) in fluid communication with a vacuum environment (140) via a common vacuum header (110). The furnace environment may have one or more furnaces (125). The vacuum environment may have one or more vacuum pumps (145) configured to provide a desired pressure to the furnace environment via the common vacuum header. A vacuum control system (170) may monitor the common vacuum header and each vacuum pump, and may change the exhaust flow from the vacuum environment based on the monitoring.

## Description

### FIELD

The present disclosure relates to chemical vapor infiltration and deposition processes ("CVI/CVD"), and more specifically, to a common vacuum header for servicing of multiple CVI/CVD furnaces.

### BACKGROUND

Chemical vapor infiltration and deposition (CVI/CVD) is a known process for making composite structures such as carbon/carbon brake disks. The CVI/CVD process typically used for making carbon/carbon brake disks is sometimes referred to as "conventional" or "isothermal" CVI/CVD. This process involves passing a reactant gas or gas mixture around heated stacks of porous structures (e.g., a carbonized stack of porous structures) at absolute pressures as low as a few torr (∼400 Pa or less) in a furnace. The gas diffuses into the stack of porous materials, driven by concentration gradients, and undergoes a CVD reaction such as thermal decomposition, hydrogen reduction, co-reduction, oxidation, carbidization, or nitridation to deposit a binding matrix. The gas may be removed from the furnace using a vacuum pump.

Typically, one vacuum pump may be in direct fluid communication with one CVI/CVD furnace (e.g., each furnace may be in fluid communication with a single dedicated vacuum). In response to the vacuum pump needing servicing, the vacuum pump and corresponding furnace may be shutdown and/or taken offline, stalling the CVI/CVD process and creating furnace downtime.

### SUMMARY

In various embodiments, a vacuum system is disclosed. The vacuum system may comprise a common vacuum header; a furnace environment in fluid communication with the common vacuum header, wherein the furnace environment comprises a plurality of furnaces; and a vacuum environment in fluid communication with the common vacuum header, wherein the vacuum environment is configured to provide a desired pressure through the furnace environment and through the common vacuum header, and wherein the vacuum environment comprises a vacuum pump.

In various embodiments, the vacuum system may further comprise a furnace isolation valve in fluid communication with the plurality of furnaces, wherein the furnace isolation valve is configured to enable or disable an exhaust flow from the plurality of furnaces to the common vacuum header. The vacuum system may also comprise a furnace control valve in fluid communication with each furnace, wherein the furnace control valve is configured to variably control an exhaust flow rate from each furnace. The vacuum system may also comprise a vacuum header isolation valve in fluid communication with each furnace control valve, wherein the vacuum header isolation valve is configured to at least one of enable or disable the exhaust flow from the furnace control valve to the common vacuum header. The vacuum system may also comprise a vacuum control valve in fluid communication with the vacuum pump, wherein the vacuum control valve is configured to variably control an exhaust flow rate from the common vacuum header to the vacuum pump. The vacuum system may also comprise a vacuum isolation valve in fluid communication with the vacuum control valve, wherein the vacuum isolation valve is configured to at least one of enable or disable the exhaust flow from the common vacuum header to the vacuum control valve. The vacuum pump may comprise at least one of a mechanical vacuum pump, a scroll vacuum pump, a fluid ejector vacuum pump, or a hybrid fluid ejector vacuum system. The vacuum system may also comprise a vacuum control system configured to monitor at least one of the common vacuum header or the vacuum pump. In response to detecting at least one of a high pressure in the common vacuum header or an impairment of the vacuum pump, the vacuum control system may be configured to increase the exhaust flow to the vacuum environment. The vacuum control system may be configured to increase the exhaust flow to the vacuum environment by enabling a second vacuum pump to provide an additional exhaust flow.

In various embodiments, a method of varying vacuum exhaust flow is disclosed. The method may comprise monitoring, by a vacuum control system, a common vacuum header, wherein the common vacuum header is configured to provide a desired pressure from a vacuum environment to a furnace environment, and wherein the vacuum environment comprises a vacuum pump; monitoring, by the vacuum control system, the vacuum pump; and changing, by the vacuum control system, an exhaust flow to the vacuum environment from the common vacuum header based on the monitoring.

In various embodiments, the vacuum control system may be configured to monitor a pressure of the exhaust flow in the common vacuum header. The vacuum control system may also be configured to monitor the vacuum pump to detect an impairment in the vacuum pump. The vacuum control system may manage the exhaust flow by enabling or disabling a second vacuum pump. The vacuum control system may change the exhaust flow by actuating a vacuum control valve in fluid communication with the vacuum pump, wherein the vacuum control valve is configured to variably control an exhaust flow rate from the common vacuum header to the vacuum pump.

In various embodiments, a vacuum system for CVI/CVD furnaces is disclosed. The vacuum system may comprise a plurality of furnaces in fluid communication with a common vacuum header; a plurality of vacuum pumps in fluid communication with the common vacuum header, wherein the vacuum pumps are configured to provide a desired pressure to the furnaces through the common vacuum header; and a vacuum control system in logical communication with the common vacuum header and the vacuum pumps, wherein the vacuum control system is configured to detect at least one of a pressure in the common vacuum header or an impairment in the vacuum pumps.

In various embodiments, the vacuum control system may be configured to change an exhaust flow rate to the vacuum pumps through the common vacuum header in response to detecting a change in pressure in the common vacuum header. The vacuum control system may also be configured to change the exhaust flow to the vacuum pumps by enabling at least one of the vacuum pumps. The common vacuum header may comprise a plurality of exhaust flow pipes. The vacuum pumps may comprise a mechanical vacuum pump, a scroll vacuum pump, a single-stage fluid ejector vacuum pump, a multi-stage steam ejector vacuum pump, and/or a hybrid fluid ejector vacuum system.

The forgoing features and elements may be combined in various combinations without exclusivity, unless expressly indicated herein otherwise. These features and elements as well as the operation of the disclosed embodiments will become more apparent in light of the following description and accompanying drawings.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the following illustrative figures. In the following figures, like reference numbers refer to similar elements and steps throughout the figures.
FIG. 1A illustrates a schematic view of a vacuum system, in accordance with various embodiments;
FIG. 1B illustrates a schematic view of a vacuum system having a common vacuum header with multiple pipes, in accordance with various embodiments; and
FIG. 2 illustrates a process flow for a method of varying vacuum exhaust flow in a vacuum system, in accordance with various embodiments.

Elements and steps in the figures are illustrated for simplicity and clarity and have not necessarily been rendered according to any particular sequence. For example, steps that may be performed concurrently or in different order are illustrated in the figures to help to improve understanding of embodiments of the present disclosure.

### DETAILED DESCRIPTION

The detailed description of exemplary embodiments herein makes reference to the accompanying drawings, which show exemplary embodiments by way of illustration. While these exemplary embodiments are described in sufficient detail to enable those skilled in the art to practice the disclosures, it should be understood that other embodiments may be realized and that logical changes and adaptations in design and construction may be made in accordance with this disclosure and the teachings herein. Thus, the detailed description herein is presented for purposes of illustration only and not of limitation.

The scope of the disclosure is defined by the appended claims and their legal equivalents rather than by merely the examples described. For example, the steps recited in any of the method or process descriptions may be executed in any order and are not necessarily limited to the order presented. Furthermore, any reference to singular includes plural embodiments, and any reference to more than one component or step may include a singular embodiment or step. Also, any reference to attached, fixed, coupled, connected or the like may include permanent, removable, temporary, partial, full and/or any other possible attachment option. Additionally, any reference to without contact (or similar phrases) may also include reduced contact or minimal contact. Surface shading lines may be used throughout the figures to denote different parts but not necessarily to denote the same or different materials.

Carbon/carbon parts ("C/C") in the form of friction disks (also referred to as a carbon/carbon brake disks) are commonly used for aircraft brake disks, race car brakes, and clutch disks. Carbon/carbon brake disks are especially useful in these applications because of the superior high temperature characteristics of C/C material. In particular, the carbon/carbon material used in C/C parts is a good conductor of heat and is able to dissipate heat generated during braking away from the braking surfaces. Carbon/carbon material is also highly resistant to heat damage, and thus, is capable of sustaining friction between brake surfaces during severe braking without a significant reduction in the friction coefficient or mechanical failure. Furthermore, carbon/carbon brake disks are useful because they are relatively light weight, in particular in comparison to previous steel brakes.

One method of manufacturing C/C materials involves fabrication of a preform from an oxidized polyacrylonitrile (PAN) (also referred to as "OPF") or carbon fiber, followed by carbonization and chemical vapor infiltration (CVI) densification of the preform. As used herein, a preform may comprise any porous structure, and the terms preform, fibrous preform, and porous structure may be used interchangeably. The CVI/CVD process cycles are continued, in conjunction with machining the preform between infiltration cycles if desired, until the desired part density is achieved. In various embodiments, machining the surfaces of the preform may open surface porosity, thereby facilitating weight increases (i.e., density increases) in the preform during subsequent densification steps.

In general, C/C parts produced using the OPF, carbonization, and CVI/CVD densification method are made in three successive manufacturing steps. First, a preform is made utilizing a variety of textile manufacturing techniques. Typically, the preform is made from OPF or carbon fiber. Although numerous techniques are known in the art for making preforms from OPF, a common technique involves stacking layers of OPF to superimpose the layers. The added layers may then be needled perpendicularly to the layers with barbed textile needles. The needling process generates a series of z-fibers through the preform that extend perpendicularly to the fibrous layers. The z-fibers are generated through the action of the needles pushing fibers from within the layer (x-y or in-plane) and reorienting them in the z-direction (through-thickness). Needling of the preform may be done as one or more layers are added to the stack or may be done after the entire stack is formed. The needles may also penetrate through only a portion of the preform or may penetrate through the entire preform. In addition, resins are sometimes added to the preform by either injecting the resin into the preform following construction or coating the fibers or layers prior to forming the preform. Preforms may also be made from pitch based carbon fiber tows and/or from rayon carbon fiber tows.

After the preform is made, it is carbonized to convert the OPF into carbon fibers in a process referred to herein as carbonization/graphitization. Typically, preforms are carbonized by placing the preforms in a furnace with an inert atmosphere. As used herein, the phrase "furnace" may include any suitable furnace, vessel, tank, and/or the like. As is well-understood by those in the art, the heat of the furnace causes a chemical conversion which drives off the non-carbon chemicals from the preform. Carbonization/graphitization may be conducted in a vacuum or partial vacuum (e.g., at pressures of 1-15 torr) or in an inert atmosphere at a temperature in the range from about 1,400°C to about 2,800°C (2,552°F to about 5,072°F), and in various embodiments in the range from about 1,400°C to about 2,500°C (2,552°F to about 4,532°F), and in various embodiments in the range from about 1,400°C to about 2,200°C (2,552°F to about 3,992°F) (wherein the term about in this context only means +/- 100°C) for a period of time in the range of up to about 60 hours, and in various embodiments, in the range up to about 10 hours (wherein the term about in this context only means +/- 2 hours). The resulting preform generally has the same fibrous structure as the preform before carbonizing. However, the OPF have been converted to 100% carbon or very near 100%, for example from 95% carbon to 99.9% carbon. The resulting preform may be referred to as having a fibrous network. In various embodiments, the preform may comprise any geometry.

After the preform has been carbonized, the preform is densified. The preform may be referred to as a "porous structure" before and during densification. In general, densification involves filling the voids, or pores, of the preform with additional carbon material. This may be done using the same furnace used for carbonization or a different furnace. Typically, chemical vapor infiltration and deposition ("CVI/CVD") techniques are used to densify the preform with a carbon matrix. This commonly involves heating the furnace and the preforms, and flowing a reactant gas comprising, for example, hydrocarbon gases (e.g., at least one of methane, ethane, propane, cyclopentane, hydrogen, nitrogen, helium, argon, an alkane, and/or the like, as described herein) into the furnace and around and through the preforms. The hydrocarbons may comprise alkanes, for example, straight chain, branched chain and/or cyclic alkanes, having from 1 to about 8 carbon atoms, and in various embodiments from 1 to about 6 carbon atoms, and in various embodiments from 1 to about 3 carbon atoms. Methane, ethane, propane, cyclopentane, or mixtures of two or more thereof may be used. The reactant gas may comprise one or more alkanes of 2 to about 8 carbon atoms, and in various embodiments from 2 to about 6 carbon atoms. Mixtures of one or more alkanes of 1 to about 8 carbon atoms with one or more alkenes of 2 to about 8 carbon atoms may be used. In various embodiments, the CVI/CVD process may include a temperature gradient. In various embodiments, the CVI/CVD process may include a pressure differential. As used herein, CVI/CVD may refer to chemical vapor infiltration or chemical vapor deposition. Accordingly, CVI/CVD may refer to chemical vapor infiltration or deposition.

CVI/CVD densification may be conducted in a vacuum or partial vacuum (e.g., at pressures of 1-15 torr (133 Pa to 1999 Pa) or in an inert atmosphere at a temperature in the range from about 900°C to about 1100°C (1,652°F to about 2012°F), and in various embodiments in the range of up to about 1,000°C (1,832°F) (wherein the term about in this context only means +/- 100°C) for a period of time in the range from about 150 hours to about 550 hours, and in various embodiments, in the range from about 300 hours to about 700 hours (wherein the term about in this context only means +/- 24 hours). The number of hours used in a CVI/CVD process may be referred to as hours on gas ("HOG").

As a result, carbon decomposes or pyrolyzes from the hydrocarbon reactant gases and is deposited on and within the preforms. Typically, the densification process is continued until the preform reaches a density in the range from 1.6 to 1.9 grams per cubic centimeter (g/cc), and in various embodiments, a density of approximately 1.75 g/cc. When the densification step is completed, the resulting C/C part has a carbon fiber structure with a carbon matrix infiltrating the fiber structure, thereby deriving the name "carbon/carbon."

The term "composite structure" may refer to a densified porous structure. The composite structure may comprise a porous structure with a solid residue or matrix dispersed within. The composite structure may comprise a carbonaceous porous structures with a carbonaceous matrix dispersed within. This may be referred to as a carbon/carbon composite. The composite structure may comprise a ceramic porous structure with a ceramic or oxide matrix dispersed within. The composite structure may comprise a mixed or hybrid composite structure such as a carbon porous structure with a ceramic or oxide matrix dispersed within, a carbon porous structure with a mix of carbon and ceramic or oxide matrix dispersed within, a ceramic porous structure with a carbon matrix dispersed within, a ceramic porous structure with a mix of carbon and ceramic or oxide matrix dispersed within, and/or the like. In various embodiments, the composite structure may comprise carbon, silicon, silicon carbide, silicon nitride, boron, boron carbide, aluminum nitride, titanium nitride, cubic zirconia, and SiCₓN_{y}, where x is a number in the range from about zero to about 1, and y is a number in the range from about zero to about 4/3. The composite structure may comprise a first surface, a second surface and at least one other surface connecting the first surface and the second surface. In various embodiments, and as used herein, any surface may comprise any suitable shape, such as, for example, at least one of rounded, sphere shaped, toroid shaped, or frustoconical.

The terms "higher order rough laminar structure," "rough laminar microstructure," "transitional microstructure," "smooth laminar microstructure," "transitional microstructure," "dark laminar" and "isotropic" may be used to describe the microstructure of a composite structure employing a carbon matrix dispersed in the porous materials. The microstructure may be determined by use of polarized light microscopy. A carbon/carbon composite with a rough laminar structure may be characterized as having high optical activity and numerous irregular extinction crosses. A carbon/carbon composite with a smooth laminar structure may be characterized as having low optical activity and smooth extinction crosses. A carbon/carbon composite with little to no optical activity may be characterized as dark laminar or isotropic. These microstructures may be quantified in terms of their extinction angles.

As used herein, the term "stack of porous structures" may be interchangeable with "porous structures stack." A porous structure stack may comprise any number of porous structures on top of one another. In this regard, the porous structures may be in contact with each other in the porous structure stack. The porous structure stack may also comprise porous structures stacked on top of one another, with spacers, and/or other hardware, separating each individual porous structure. In this regard, the porous structures may be stacked such that each porous structure is not in contact with another porous structure (i.e., the spacers are in contact with the porous structures).

In various embodiments, pressure differentials may also be used with thermal gradients. A pressure differential may be created when pressure on one surface of a stack of porous structures is different than the pressure at another surface of the stack of porous structures.

Composite structures made according to various embodiments may be useful as carbon/carbon aircraft disk brakes, ceramic combustion and turbine components such as turbine engine hot section components, ceramic friction materials, ceramic heat sinks, and the like. The carbon/carbon disk brakes may be in the form of circular disks or disks.

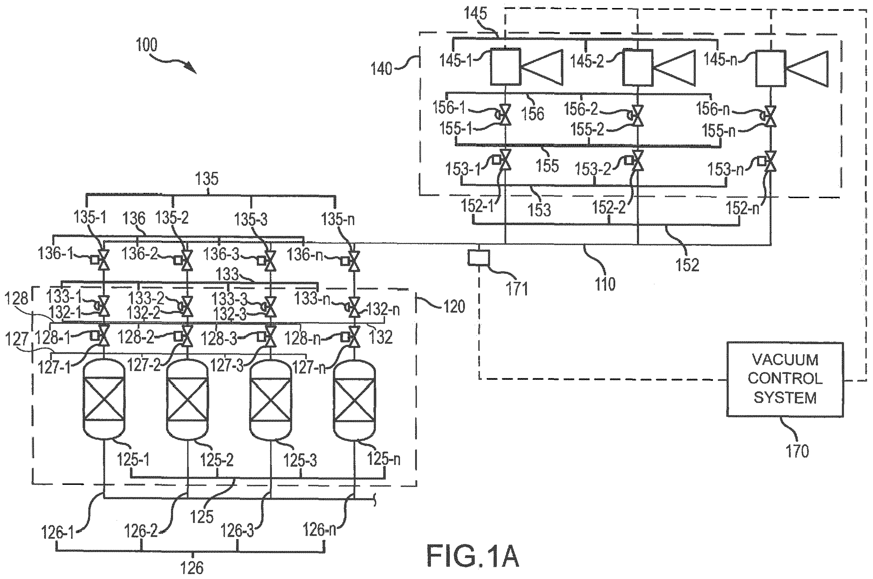

In various embodiments, and with reference to FIG. 1A, a vacuum system 100 for CVI/CVD processes is disclosed. Vacuum system 100 may comprise a furnace environment 120 in fluid communication with a vacuum environment 140 via a common vacuum header 110. As discussed further herein, vacuum system 100 may allow for one or more CVI/CVD furnaces (e.g., furnaces 125) in furnace environment 120 to be in fluid communication with one or more vacuum sources (e.g., vacuum pumps 145) in vacuum environment 140. Use of a common vacuum header 110 to route the sum of all reactant gas from furnace environment 120 may allow for maintenance to be performed on individual vacuum sources without interrupting production in furnace environment 120, and without needing to take any corresponding furnace offline and off-production. In that respect, vacuum system 100 may improve production capacity in furnace environment 120 by at least 5%-10% by decreasing the downtime of each individual furnace caused by vacuum maintenance. Moreover, routing the sum of all reactant gas from furnace environment 120 to vacuum environment 140 may also at least partially extend vacuum system uptime between maintenance periods (e.g., having a common vacuum source may equalize and/or normalize the quality of the reactant gas by distributing the sum of all gases to each separate vacuum, thus delivering a more consistent quality of reactant gas to each vacuum). Although the present disclosure makes reference to CVI/CVD furnaces, it should be understood that the present disclosure may extend to any other suitable industry or use, such as, for example, processing, drying, and/or other such similar industries.

In various embodiments, furnace environment 120 may comprise one or more furnaces 125. For example, furnace environment 120 may comprise a first furnace 125-1, a second furnace 125-2, a third furnace 125-3, and/or an "Nth" furnace 125-n. Furnace environment 120 may comprise any suitable and/or desired number of furnaces 125. Each furnace 125 may comprise any suitable and/or desired type of furnace. For example, furnaces 125 may comprise a CVI/CVD furnace as discussed herein. In that respect, each furnace 125 may be configured to enclose one or more porous structure stacks that are to undergo a CVI/CVD process. Each furnace 125 may include a reactant gas feed line 126 configured to facilitate flow of reactant gas from a reactant gas source into each furnace 125 (e.g., first furnace 125-1 may be in fluid communication with a first gas feed line 126-1, second furnace 125-2 may be in fluid communication with a second gas feed line 126-2, third furnace 125-3 may be in fluid communication with a third gas feed line 126-3, and/or Nth furnace 125-1 may be in fluid communication with a "Nth" gas feed line 126-n). The reactant gas may be exhausted from each furnace 125 into common vacuum header 110.

In various embodiments, vacuum environment 140 may be configured to provide a desired pressure through common vacuum header 110 to furnace environment 120. In that regard, vacuum environment 140 may comprise one or more vacuum pumps 145. For example, vacuum environment 140 may comprise a first vacuum pump 145-1, a second vacuum pump 145-2, and/or an "Nth" vacuum pump 145-n. Vacuum environment 140 may comprise any suitable and/or desired number of vacuum pumps 145. In that respect, the number of vacuum pumps 145 in vacuum environment 140 may be scaled based on the number of furnaces in furnace environment 120, processing considerations, and/or other such operational factors. Each vacuum pump 145 may comprise any suitable and/or desired type of vacuum capable of creating suction to remove gases (e.g., an exhaust flow) from furnace environment 120, via common vacuum header 110. For example, vacuum pumps 145 may comprise a mechanical vacuum pump, a scroll vacuum pump, a fluid ejector vacuum pump (e.g., a steam ejector vacuum pump), a hybrid fluid ejector vacuum system, and/or any other suitable vacuum, compressor, and/or the like. The fluid ejector vacuum pump may comprise a single-stage ejector pump or a multi-stage ejector pump, and may have a single-nozzle or multiple-nozzle design.

In various embodiments, use of common vacuum header 110 to separate vacuum environment 140 and furnace environment 120 may allow vacuum environment 140 and furnace environment 120 to be in different locations. For example, furnace environment 120 and vacuum environment 140 may be located in different buildings, in different rooms in the same building, and/or the like. Typical vacuum environments 140 may emit undesirable levels of noise from vacuum operation and those near such equipment may benefit from hearing protection. By separating vacuum environment 140 from furnace environment 120, furnace environment 120 may achieve reduced noise levels, which is beneficial ergonomically.

In various embodiments, common vacuum header 110 may be configured to withdraw reactant gas from furnace environment 120. In that respect, common vacuum header 110 may serve as a common suction distribution header for each furnace 125 in furnace environment 120. Common vacuum header 110 may be in fluid communication with each furnace 125 in furnace environment 120 (e.g., first furnace 125-1, second furnace 125-2, third furnace 125-3, and/or Nth furnace 125-n). Common vacuum header 110 may be in fluid communication with each vacuum pump 145 in vacuum environment 140 (e.g., first vacuum pump 145-1, second vacuum pump 145-2, and/or Nth vacuum pump 145-n). In that respect, each vacuum pump 145 in fluid communication with common vacuum header 110 may provide an exhaust flow, via common vacuum header 110, to collectively evacuate gas from each furnace 125 in fluid communication with common vacuum header 110.

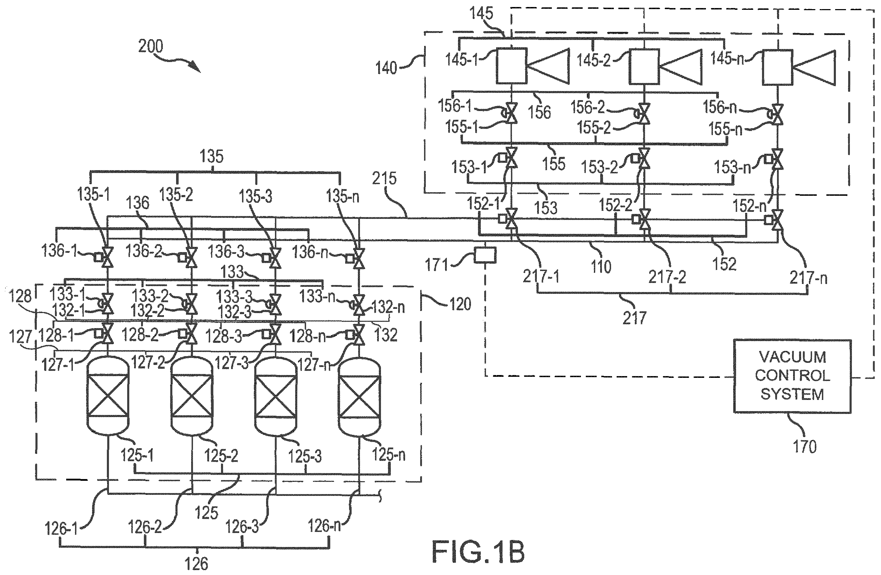

Common vacuum header 110 may comprise one or more exhaust flow pipes, and/or any other suitable mechanism capable of transporting gas from furnace environment 120 to vacuum environment 140. For example, common vacuum header 110 may comprise multiple exhaust flow pipes configured for redundancy. In that respect, and with brief reference to FIG. 1B, vacuum system 200 may comprise a second common vacuum header 215. Second common vacuum header 215 may be similar to common vacuum header 110 and may be configured to provide exhaust flow to vacuum environment 140 from furnace environment 120. Second common vacuum header 215 may provide exhaust flow at least partially simultaneously with common vacuum header 110, or may provide redundancy for common vacuum header 110. For example, second common vacuum header 215 and/or common vacuum header 110 may be in fluid communication with one or more vacuum header diverting valves 217 (e.g., a first vacuum header diverting valve 217-1, a second vacuum header diverting valve 217-2, and/or a "Nth" vacuum header diverting valve 217-n). Each vacuum header diverting valve 217 may provide logic to route exhaust flow to vacuum environment 140 from second common vacuum header 215 and/or common vacuum header 110. In various embodiments, vacuum system 200 may comprise any suitable and/or desired number of common vacuum headers.

In various embodiments, and with reference again to FIG. 1A, each furnace 125 in furnace environment 120 may be in fluid communication with common vacuum header 110 via one or more valves configured to control and/or vary the exhaust flow to common vacuum header 110 from each furnace 125. The various valves as discussed herein may comprise various types of valves known to a person having ordinary skill in the art, for example, ball valves, parabolic plughead valves, hemispherical plughead valves, flat plug head valves, and/or other suitable valves. For example, and in various embodiments, each furnace 125 may be in fluid communication with one or more furnace isolation valves 127 (e.g., first furnace 125-1 in fluid communication with a first furnace isolation valve 127-1, second furnace 125-2 in fluid communication with a second furnace isolation valve 127-2, third furnace 125-3 in fluid communication with a third furnace isolation valve 127-3, and/or Nth furnace 125-n in fluid communication with an "Nth" furnace isolation valve 127-n). Each furnace isolation valve 127 may be configured to enable or disable the exhaust flow from the corresponding furnace 125. For example, each furnace isolation valve 127 may comprise a furnace isolation valve actuator 128 (e.g., a first furnace isolation valve actuator 128-1, a second furnace isolation valve actuator 128-2, a third furnace isolation valve actuator 128-3, and/or a "Nth" furnace isolation valve actuator 128-n). Each furnace isolation valve actuator 128 may comprise electronics, motors, and/or the like configured to actuate the corresponding furnace isolation valve 127 to enable or disable exhaust flow. For example, actuation of each furnace isolation valve 127 via the corresponding furnace isolation valve actuator 128 may operate to enable or disable the exhaust flow from the corresponding furnace 125 (e.g., in a "disabled" position, furnace isolation valve 127 may restrict the exhaust flow from the corresponding furnace 125, and in an "enabled" position, furnace isolation valve 127 may allow the exhaust flow from the corresponding furnace 125).

In various embodiments, each furnace 125 may also be in fluid communication with one or more furnace control valves 132 (e.g., first furnace 125-1 in fluid communication with a first furnace control valve 132-1, second furnace 125-2 in fluid communication with a second furnace control valve 132-2, third furnace 125-3 in fluid communication with a third furnace control valve 132-3, and/or Nth furnace 125-n in fluid communication with an "Nth" furnace control valve 132-n). Each furnace control valve 132 may be configured to control and/or vary the volumetric level of exhaust flow from the corresponding furnace 125. For example, each furnace control valve 132 may comprise a furnace control valve actuator 133 (e.g., a first furnace control valve actuator 133-1, a second furnace control valve actuator 133-2, a third furnace control valve actuator 133-3, and/or a "Nth" furnace control valve actuator 133-n). Each furnace control valve actuator 133 may comprise electronics, motors, and/or the like configured to actuate the corresponding furnace control valve 132 to vary the volumetric level of exhaust flow. For example, actuation of furnace control valve 132 via furnace control valve actuator 133 may vary the size of the flow passage through furnace control valve 132 to control an exhaust flow rate through furnace control valve 132. Each furnace control valve 132 may be located downstream from each corresponding furnace 125 (wherein "upstream" as used in this context refers to a position closer to furnace 125, and "downstream" refers to a position further away from furnace 125). In that respect, each furnace control valve 132 may control the exhaust flow rate from each furnace 125 (via furnace isolation valve 127).

In various embodiments, each furnace 125 may also be in fluid communication with one or more vacuum header isolation valves 135 (e.g., first furnace 125-1 in fluid communication with a first vacuum header isolation valve 135-1, second furnace 125-2 in fluid communication with a second vacuum header isolation valve 135-2, third furnace 125-3 in fluid communication with a third vacuum header isolation valve 135-3, and/or Nth furnace 125-n in fluid communication with an "Nth" vacuum header isolation valve 135-n). Each vacuum header isolation valve 135 may be configured to enable or disable the exhaust flow from the corresponding furnace 125. For example, each vacuum header isolation valve 135 may comprise a vacuum header isolation valve actuator 136 (e.g., a first vacuum header isolation valve actuator 136-1, a second vacuum header isolation valve actuator 136-2, a third vacuum header isolation valve actuator 136-3, and/or a "Nth" vacuum header isolation valve actuator 136-n). Each vacuum header isolation valve actuator 136 may comprise electronics, motors, and/or the like configured to actuate the corresponding vacuum header isolation valve 135 to enable or disable exhaust flow. For example, actuation of each vacuum header isolation valve 135 via vacuum header isolation valve actuator 136 may operate to enable or disable the exhaust flow from the corresponding furnace 125 (e.g., in a "disabled" position, vacuum header isolation valve 135 may restrict the exhaust flow from the corresponding furnace 125, and in an "enabled" position, vacuum header isolation valve 135 may allow the exhaust flow from the corresponding furnace 125). Each vacuum header isolation valve 135 may be located downstream from each furnace control valve 132 and furnace isolation valve 127 (wherein "upstream" as used herein refers to a position closer to furnace 125, and "downstream" refers to a position further away from furnace 125). In that respect, each vacuum header isolation valve 135 may supply and/or restrict the exhaust flow from each furnace control valve 132 and/or furnace isolation valve 127.

In various embodiments, each vacuum pump 145 in vacuum environment 140 may be in fluid communication with common vacuum header 110 via one or more valves configured to control, manage, and/or vary the exhaust flow to each vacuum pump 145 from common vacuum header 110. The various valves as discussed herein may comprise various types of valves known to a person having ordinary skill in the art, for example, ball valves, parabolic plughead valves, hemispherical plughead valves, flat plug head valves, and/or other suitable valves. For example, and in various embodiments, each vacuum pump 145 may be in fluid communication with one or more vacuum control valves 155 (e.g., first vacuum pump 145-1 in fluid communication with a first vacuum control valve 155-1, second vacuum pump 145-2 in fluid communication with a second vacuum control valve 155-2, and/or Nth vacuum pump 145-n in fluid communication with an "Nth" vacuum control valve 155-n). Each vacuum control valve 155 may be configured to control the volumetric level of exhaust flow to each corresponding vacuum pump 145. For example, each vacuum control valve 155 may comprise a vacuum control valve actuator 156 (e.g., a first vacuum control valve actuator 156-1, a second vacuum control valve actuator 156-2, and/or a "Nth" vacuum control valve actuator 156-n). Each vacuum control valve actuator 156 may comprise electronics, motors, and/or the like configured to control actuation of each corresponding vacuum control valve 155. For example, actuation of vacuum control valve 155 via vacuum control valve actuator 156 may vary the size of the flow passage through vacuum control valve 155 to control an exhaust flow rate through vacuum control valve 155.

In various embodiments, each vacuum pump 145 may also be in fluid communication with one or more vacuum isolation valves 152 (e.g., first vacuum pump 145-1 in fluid communication with a first vacuum isolation valve 152-1, second vacuum pump 145-2 in fluid communication with a second vacuum isolation valve 152-2, and/or Nth vacuum pump 145-n in fluid communication with an "Nth" vacuum isolation valve 152-n). Each vacuum isolation valve 152 may be configured to enable or disable the exhaust flow to each corresponding vacuum pump 145 from common vacuum header 110. For example, each vacuum isolation valve 152 may comprise a vacuum isolation valve actuator 153 (e.g., a first vacuum isolation valve actuator 153-1, a second vacuum isolation valve actuator 153-2, and/or a "Nth" vacuum isolation valve actuator 153-n). Each vacuum isolation valve actuator 153 may comprise electronics, motors, and/or the like configured to control actuation of the corresponding vacuum isolation valve 152. For example, actuation of each vacuum isolation valve 152 via vacuum isolation valve actuator 153 may operate to enable or disable the exhaust flow from common vacuum header 110 (e.g., in a "disabled" position, vacuum isolation valve 152 may restrict the exhaust flow from common vacuum header 110, and in an "enabled" position, vacuum isolation valve 152 may allow the exhaust flow from common vacuum header 110). Each vacuum isolation valve 152 may be located upstream from each corresponding vacuum control valve 155 (wherein "downstream" as used herein refers to a position closer to vacuum pump 145, and "upstream" refers to a position further away from vacuum pump 145). In that respect, each vacuum control valve 155 may enable and/or disable the exhaust flow to each corresponding vacuum pump 145 from common vacuum header 110.

In various embodiments, vacuum system 100 may comprise a vacuum control system 170. Vacuum control system 170 may be configured to monitor vacuum system 100 and manage and/or vary the exhaust flow provided to vacuum environment 140 based on the monitoring. Vacuum control system 170 may comprise one or more processors, controllers, and/or any other suitable electronic components capable of monitoring vacuum system 100. Vacuum control system 170 may also be configured to execute instructions loaded onto a tangible, non-transitory computer readable medium, causing vacuum control system 170 to perform various operations.

System program instructions and/or controller instructions may be loaded onto a non-transitory, tangible computer-readable medium having instructions stored thereon that, in response to execution by a controller, cause the controller to perform various operations. The term "non-transitory" is to be understood to remove only propagating transitory signals per se from the claim scope and does not relinquish rights to all standard computer-readable media that are not only propagating transitory signals per se.

In various embodiments, vacuum control system 170 may be configured to monitor common vacuum header 110. In that respect, vacuum control system 170 may be in operative communication with common vacuum header 110. For example, vacuum control system 170 may comprise a pressure monitoring instrument 171 in fluid communication with common vacuum header 110. Pressure monitoring instrument 171 may be configured to monitor a pressure in common vacuum header 110 (e.g., a pressure of the exhaust flow through common vacuum header 110). For example, vacuum control system 170, via pressure monitoring instrument 171, may monitor common vacuum header 110 to detect a low pressure or a high pressure.

In various embodiments, vacuum control system 170 may also be configured to monitor each vacuum pump 145 in vacuum environment 140. In that respect, vacuum control system 170 may be in logical communication with each vacuum pump 145 (e.g., first vacuum pump 145-1, second vacuum pump 145-2, and/or Nth vacuum pump 145-n). Vacuum control system 170 may monitor each vacuum pump 145 to detect an impairment (e.g., a fouling, etc.) in each vacuum pump 145, and/or any other type of maintenance problem. For example, vacuum control system 170 may comprise instrumentation coupled to or in proximity to each vacuum pump 145 and configured to measure the accumulation of material, contaminate, particulate, and/or similar unwanted impairment of vacuum pump 145.

In various embodiments, vacuum control system 170 may be configured to manage and/or vary the exhaust flow provided to vacuum environment 140 based on the monitoring of common vacuum header 110 and/or each vacuum pump 145. In that respect, vacuum control system 170 may increase or decrease the exhaust flow by enabling or disabling a vacuum pump 145 in vacuum environment 140 (e.g., putting a second vacuum pump 145 online or offline). For example, vacuum control system 170 may transmit electronic signals to the corresponding vacuum pump 145 to disable or enable the vacuum pump 145. The corresponding vacuum isolation valve 152 for the vacuum pump 145 may be actuated to restrict exhaust flow before the vacuum pump 145 is disabled. Vacuum control system 170 may also alert maintenance and/or the like to manually disable or enable the corresponding vacuum pump 145. Vacuum control system 170 may also increase or decrease the exhaust flow by actuating corresponding vacuum control valves 155. For example, vacuum control system 170 may transmit electronic signals to cause the corresponding vacuum control valve 155 to decrease or increase the volumetric exhaust flow allowed through vacuum control valve 155. Vacuum control system 170 may also alert maintenance and/or the like to manually adjust the corresponding vacuum control valve 155 to decrease or increase the volumetric exhaust flow.

As an example, and in various embodiments, in response to vacuum control system 170 detecting a high pressure in common vacuum header 110, vacuum control system 170 may increase the exhaust flow by enabling at least a second vacuum pump 145 to provide an additional exhaust flow, and/or by actuating one or more vacuum control valves 155 to increase the volumetric exhaust flow to the corresponding vacuum pump 145. In response to vacuum control system 170 detecting a low pressure exhaust flow in common vacuum header 110, vacuum control system 170 may decrease the exhaust flow by disabling at least one vacuum pump 145 to decrease the exhaust flow and/or by actuating one or more vacuum control valves 155 to decrease the volumetric exhaust flow to the corresponding vacuum pump 145. In response to vacuum control system 170 detecting an impairment of one or more vacuum pumps 145 in vacuum environment 140, vacuum control system 170 may disable the impaired vacuum pump 145 and may enable at least a second vacuum pump 145 to provide an additional exhaust flow, and/or may actuate one or more vacuum control valves 155 corresponding to the enabled vacuum pump 145 to increase the volumetric exhaust flow to that corresponding enabled vacuum pump 145. For example, the corresponding vacuum isolation valve 152 for the impaired vacuum pump 145 may be actuated to restrict exhaust flow before that impaired vacuum pump 145 is disabled. The corresponding vacuum isolation valve 152 for the enabled second vacuum pump may be actuated to allow exhaust flow after the vacuum pump 145 is enabled.

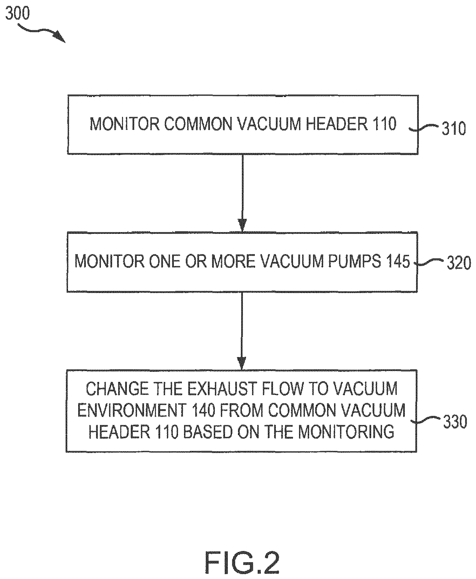

In various embodiments, and with reference to FIGs. 2 and 1A, a method 300 for varying and/or managing vacuum exhaust flow is disclosed. Method 300 may allow for maintenance to be performed on individual vacuum pumps 145 without interrupting production in furnace environment 120, and without needing to take any corresponding furnace 125 offline and/or off-production. In that regard, the exhaust flow through common vacuum header 110 may be varied and/or managed to account for a vacuum pump 145 being disabled. In various embodiments, method 300 may comprise monitoring common vacuum header 110 (Step 310). Vacuum control system 170 may be configured to monitor common vacuum header 110. For example, vacuum control system 170 may monitor common vacuum header 110 to determine a pressure in common vacuum header 110 (e.g., a low pressure exhaust flow or a high pressure exhaust flow). Method 300 may comprise monitoring one or more vacuum pumps 145 in vacuum environment 140 (Step 320). Vacuum control system 170 may be configured to monitor each vacuum pump 145 in vacuum environment 140. Vacuum control system 170 may monitor each vacuum pump 145 to detect an impairment in each vacuum pump 145.

In various embodiments, method 300 may comprise changing the exhaust flow to vacuum environment 140 from common vacuum header 110 based on the monitoring (Step 330). Vacuum control system 170 may be configured to change the exhaust flow of vacuum environment 140. In that respect, vacuum control system 170 may increase or decrease the exhaust flow by enabling or disabling one or more vacuum pumps 145 in vacuum environment 140 (e.g., putting at least second vacuum pump 145 online or offline). For example, vacuum control system 170 may transmit electronic signals to the corresponding vacuum pump 145 to disable or enable the vacuum pump 145. The corresponding vacuum isolation valve 152 for the vacuum pump 145 may be actuated to restrict exhaust flow before the vacuum pump 145 is disabled. Vacuum control system 170 may also alert maintenance and/or the like to manually disable or enable the corresponding vacuum pump 145. Vacuum control system 170 may also increase or decrease the exhaust flow by actuating corresponding vacuum control valves 155. For example, vacuum control system 170 may transmit electronic signals to cause the corresponding vacuum control valve 155 to decrease or increase the volumetric exhaust flow allowed through vacuum control valve 155. Vacuum control system 170 may also alert maintenance and/or the like to manually adjust the corresponding vacuum control valve 155 to decrease or increase the volumetric exhaust flow.

As an example, and in various embodiments, in response to vacuum control system 170 detecting a high pressure in common vacuum header 110, vacuum control system 170 may increase the exhaust flow by enabling at least a second vacuum pump 145 to provide an additional exhaust flow and/or by actuating one or more vacuum control valves 155 to increase the volumetric exhaust flow to the corresponding vacuum pump 145. In response to vacuum control system 170 detecting a low pressure exhaust flow in common vacuum header 110, vacuum control system 170 may decrease the exhaust flow by disabling at least one vacuum pump 145 to decrease the exhaust flow and/or by actuating one or more vacuum control valves 155 to decrease the volumetric exhaust flow to the corresponding vacuum pump 145. In response to vacuum control system 170 detecting an impairment of one or more vacuum pumps 145 in vacuum environment 140, vacuum control system 170 may disable the fouled vacuum pump 145 and may enable at least a second vacuum pump 145 to provide an additional exhaust flow and/or may actuate one or more vacuum control valves 155 corresponding to enabled vacuum pumps 145 to increase the volumetric exhaust flow to the corresponding vacuum pump 145. For example, the corresponding vacuum isolation valve 152 for the vacuum pump 145 may be actuated to restrict exhaust flow before the vacuum pump 145 is disabled.

Benefits, other advantages, and solutions to problems have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the disclosures. The scope of the disclosures is accordingly to be limited by nothing other than the appended claims and their legal equivalents, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C.

Systems, methods and apparatus are provided herein. In the detailed description herein, references to "various embodiments", "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

## Claims

1. A vacuum system, comprising:
a common vacuum header (110);
a furnace environment (120) in fluid communication with the common vacuum header, wherein the furnace environment comprises a plurality of furnaces; and
a vacuum environment (140) in fluid communication with the common vacuum header, wherein the vacuum environment is configured to provide a desired pressure through the common vacuum header from the furnace environment, and wherein the vacuum environment comprises a vacuum pump (145).

2. The vacuum system of claim 1, further comprising a furnace isolation valve (127) in fluid communication with the plurality of furnaces, wherein the furnace isolation valve is configured to enable or disable an exhaust flow from the plurality of furnaces to the common vacuum header.

3. The vacuum system of claim 1 or 2, further comprising a furnace control valve (132) in fluid communication with each furnace, wherein the furnace control valve is configured to variably control an exhaust flow rate from each furnace.

4. The vacuum system of claim 3, further comprising a vacuum header isolation valve (135) in fluid communication with each furnace control valve, wherein the vacuum header isolation valve is configured to at least one of enable or disable the exhaust flow from the furnace control valve to the common vacuum header.

5. The vacuum system of any preceding claim, further comprising a vacuum control valve (155) in fluid communication with the vacuum pump, wherein the vacuum control valve is configured to variably control an exhaust flow rate from the common vacuum header to the vacuum pump.

6. The vacuum system of claim 5, further comprising a vacuum isolation valve in fluid communication with the vacuum control valve, wherein the vacuum isolation valve is configured to at least one of enable or disable the exhaust flow from the common vacuum header to the vacuum control valve.

7. The vacuum system of any preceding claim, wherein the vacuum pump comprises at least one of a mechanical vacuum pump, a scroll vacuum pump, a fluid ejector vacuum pump, or a hybrid fluid ejector vacuum system.

8. The vacuum system of any preceding claim, further comprising a vacuum control system (170) configured to monitor at least one of the common vacuum header or the vacuum pump.

9. The vacuum system of claim 8, wherein in response to detecting at least one of a high pressure in the common vacuum header or an impairment of the vacuum pump, the vacuum control system is configured to increase the exhaust flow to the vacuum environment, and preferably wherein the vacuum control system is configured to increase the exhaust flow to the vacuum environment by enabling a second vacuum pump to provide an additional exhaust flow.

10. A method of varying vacuum exhaust flow,
monitoring, by a vacuum control system, a common vacuum header, wherein the common vacuum header is configured to provide a desired pressure to a vacuum environment from a furnace environment, and wherein the vacuum environment comprises a vacuum pump;
monitoring, by the vacuum control system, the vacuum pump; and
changing, by the vacuum control system, an exhaust flow to the vacuum environment from the common vacuum header based on the monitoring.

11. The method of claim 10, wherein the vacuum control system is configured to monitor a pressure of the exhaust flow in the common vacuum header, or wherein the vacuum control system is configured to monitor the vacuum pump to detect an impairment in the vacuum pump, or wherein the vacuum control system is configured to manage the exhaust flow by enabling or disabling a second vacuum pump, or wherein the vacuum control system is configured to change the exhaust flow by actuating a vacuum control valve in fluid communication with the vacuum pump, wherein the vacuum control valve is configured to variably control an exhaust flow rate from the common vacuum header to the vacuum pump.

12. A vacuum system for CVI/CVD furnaces, comprising:
a plurality of furnaces (125) in fluid communication with a common vacuum header (110);
a plurality of vacuum pumps (145) in fluid communication with the common vacuum header, wherein the vacuum pumps are configured to provide a desired pressure to the furnaces through the common vacuum header; and
a vacuum control system (170) in logical communication with the common vacuum header and the vacuum pumps, wherein the vacuum control system is configured to detect at least one of a pressure in the common vacuum header or an impairment in the vacuum pumps.

13. The vacuum system of claim 12, wherein the vacuum control system is configured to increase an exhaust flow rate to the vacuum pumps through the common vacuum header in response to detecting a high pressure in the common vacuum header, and preferably wherein the vacuum control system is configured to increase the exhaust flow to the vacuum pumps by enabling at least one of the vacuum pumps.

14. The vacuum system of claim 12 or 13, wherein the common vacuum header comprises a plurality of exhaust flow pipes.

15. The vacuum system of any of claims 12 to 14, wherein the vacuum pumps comprise at least one of a mechanical vacuum pump, a scroll vacuum pump, a single-stage fluid ejector vacuum pump, a multi-stage fluid ejector vacuum pump, or a hybrid fluid ejector vacuum system.
